# EUROPÄISCHE PATENTSCHRIFT

(11) **EP 2 939 505 B1**
(45) Veröffentlichungstag und Bekanntmachung des Hinweises auf die Patenterteilung: **11.07.2018**
(21) Anmeldenummer: 13830200.5
(22) Anmeldetag: 20.12.2013
(51) Int. Cl.: H05B 37/02

(54) **SCHNITTSTELLENSCHALTUNG ZUR SIGNALÜBERTRAGUNG**
INTERFACE CIRCUIT FOR SIGNAL TRANSMISSION
CIRCUIT D'INTERFACE POUR LA TRANSMISSION DE SIGNAUX

(30) Priorität: 28.12.2012 DE 102012224515
(43) Veröffentlichungstag der Anmeldung: 04.11.2015
(73) Patentinhaber: Tridonic GmbH & Co. KG, 6851 Dornbirn (AT)
(72) Erfinder: VONACH, Christoph, 6850 Dornbirn (AT)
(74) Vertreter: Rupp, Christian
(86) Internationale Anmeldenummer: PCT/AT2013/000210
(87) Internationale Veröffentlichungsnummer: WO 2014/100843

(56) Entgegenhaltungen:
- DE-A1- 4 330 114
- DE-A1-102005 018 762
- "Application Note AN10364 Opto-electrical isolation of the I2C-bus (operating the bus between points with different local ground potential)", NXP B.V. , 12 November 2010 (2010-11-12), Retrieved from the Internet: URL:http://www.nxp.com/docs/en/application -note/AN10364.pdf [retrieved on 2017-09-06]

## Beschreibung

Die vorliegende Erfindung betrifft Schnittstellen, die bspw. im Zusammenhang mit Betriebsgeräten zum Betreiben von Leuchtmitteln wie bspw. Vorschaltgeräten verwendet werden können. Insbesondere bezieht sich die Erfindung auf eine Schnittstellenschaltung zur Übertragung von Daten insbesondere Steuerbefehle zu einem Betriebsgerät für die Leuchtmittel.

Schnittstellenschaltungen zur bidirektionalen Übertragung von Daten zwischen einem Betriebsgerät für Leuchtmittel und einem Bus sind grundsätzlich bekannt. Eine derartige Schnittstelle ist beispielsweise aus der US 6,762,570 B1 bekannt. In Fig. 4 ist in dieser Druckschrift eine Schaltung gezeigt mit zwei Optokopplern zum Senden und Empfangen von Daten. Die bidirektionale Übertragung wird von einem Mikrocontroller 102 gesteuert, wobei dieser Mikrocontroller einerseits Anschlüsse zum Empfangen von Daten und andererseits davon separate Anschlüsse zum Senden von Daten aufweist. An der intelligenten Schaltung in Form des Mikrocontrollers sind im Betriebsgerät mehrere Pins für die bidirektionale Kommunikation belegt.

Aus der Application note AN10364 ist eine Trenn-Schaltung für einen I2C-Bus mit einem Sende-Optokoppler und einem Empfangs-Optokoppler bekannt.

Entsprechend hat sich die Erfindung das Ziel gesetzt, eine vereinfachte Schnittstellenschaltung zu schaffen.

Die Aufgabe der Erfindung wird durch die Merkmale des Anspruchs 1 gelöst. Vorteilhafte Ausgestaltungen und Weiterbildungen der Erfindung ergeben sich aus den abhängigen Ansprüchen.

Ein erster Aspekt der Erfindung bezieht sich auf eine Schnittstellenschaltung für ein Betriebsgerät der Hausgerätetechnik, insbesondere für ein Betriebsgerät für Leuchtmittel, zur bidirektionalen Kommunikation mit einem Bus über jeweils einen Sende-Optokoppler und einen Empfangs-Optokoppler. Ein Knotenpunkt der Schnittstellenschaltung ist mit einer Treiberspannung derart beaufschlagbar, dass der Sende-Optokoppler durchschaltet und somit ein Signal auf den Bus sendet. Am selben Knotenpunkt ist der Zustand des Empfangs-Optokopplers detektierbar, so dass ein Signal vom Bus empfangen werden kann.

Ein weiterer Aspekt der Erfindung bezieht sich auf ein Betriebsgerät für Leuchtmittel aufweisend eine derartige Schnittstellenschaltung.

Ein weiterer Aspekt der Erfindung bezieht sich auf eine Steuer- und Auswerteschaltung für eine Schnittstellenschaltung für ein Betriebsgerät der Hausgerätetechnik, insbesondere für ein Betriebsgerät für Leuchtmittel, zur bidirektionalen Kommunikation mit einem Bus über jeweils einen Sende-Optokoppler und einen Empfangs-Optokoppler. Ein Knotenpunkt der Steuer- und Auswerteschaltung ist mit einer Treiberspannung derart beaufschlagbar, dass der Sende-Optokoppler durchschaltet und somit ein Signal auf den Bus sendet. Am selben Knotenpunkt ist der Zustand des Empfangs-Optokopplers detektierbar, so dass ein Signal vom Bus empfangen werden kann. Dabei kann die Steuer- und Auswerteschaltung als integrierte Schaltung, insbesondere ASIC oder Microcontroller oder eine Hybridversion davon, ausgebildet sein.

Durch das Durchschalten des Sende-Optokopplers wird ein Signal, insbesondere ein digitales Signal, auf den Bus gesendet. Dadurch, dass der Zustand des Empfangs-Optokoppler detektierbar ist, ist es möglich, den Zustand des Busses und somit ein Signal vom Bus zu empfangen.

Der Knotenpunkt kann ein Anschluss einer Steuer- und Auswerteschaltung sein.

Die Steuer- und Auswerteschaltung kann einen Treiber zum Anliegen einer Treiberspannung am Knotenpunkt aufweisen, wobei die Treiberspannung ein Durchschalten des Sende-Optokopplers verursacht.

Die Steuer- und Auswerteschaltung kann Mittel aufweisen, z.B. einen Komparator, zum Vergleichen der Spannung am Knotenpunkt mit einer Referenzspannung. Abhängig von diesem Vergleich kann auf ein Niedrigpegel- oder Hochpegel-Signal auf dem Bus geschlossen werden.

Wenn die Spannung am Knotenpunkt größer als die Referenzspannung ist, kann auf ein Niedrigpegel-Signal auf dem Bus geschlossen werden. Wenn die Spannung am Knotenpunkt kleiner als die Referenzspannung ist, kann auf ein Hochpegel-Signal auf dem Bus geschlossen werden. Die über die Schnittstelle übertragenen Daten können sowohl als Active High Signal (d.h. eine 1 wird durch einen hohen Pegel übertragen) als auch als Active Low Signal übertragen werden (d.h. eine 1 wird durch einen niedrigen Pegel übertragen).

Der Bus kann als DALI-Bus ausgestaltet sein. Ein detektiertes Hochpegel-Signal des Busses kann als Ruhezustand des Busses interpretiert werden.

Die Steuer- und Auswerteschaltung kann als integrierte Schaltung ausgestaltet sein, vorzugsweise in Form eines Mikrocontrollers, einer anwendungsspezifischen integrierten Schaltung (ASIC) oder eines digitalen Signalprozessors.

Die Schnittstellenschaltung kann aufweisen:
- einen am Knotenpunkt (P) angeschlossenen ersten Strompfad aufweisend eine riiederohmige Schaltung (R3) und den Sende-Optokoppler (9),
- einen am Knotenpunkt (P) angeschlossenen, mit einer Versorgungsspannung (V1) versorgten, hochohmigen zweiten Strompfad, der mit einem Empfangs-Optokoppler (8) verbunden ist.

Der Empfangs-Optokoppler kann derart mit dem hochohmigen zweiten Strompfad verbunden sein, dass ein Durchschalten des Empfangs-Optokopplers am Knotenpunkt ein Niedrigpotential verursacht.

Der Empfangs-Optokoppler kann derart mit dem hochohmigen zweiten Strompfad verbunden sein, dass ein Nicht-Durchschalten des Empfangs-Optokopplers am Knotenpunkt ein Hochpotential verursacht.

Der Empfangs-Optokoppler kann derart mit dem hochohmigen zweiten Strompfad verbunden sein, dass ein Nicht-Durchschalten des Empfangs-Optokopplers ein Nicht-Durchschalten des Sende-Optokopplers verursacht.

Dem Sende-Optokoppler können einerseits die Treiberspannung und andererseits eine mit dem Empfangs-Optokoppler gekoppelte Versorgungsspannung zuführbar sein.

Die Schnittstellenschaltung kann aufweisen ein derartig ausgestaltetes asymmetrisches Widerstandsnetzwerk, das beim Zuführen der Treiberspannung der Sende-Optokoppler durchschaltet und beim Zuführen der Versorgungsspannung der Sende-Optokoppler nicht durchschaltet.

Bei Nichtbeaufschlagung des Knotenpunkts mit der Treiberspannung, wird vorzugsweise der Sende-Optokoppler nicht durchgeschaltet und die Steuer- und Auswerteschaltung das über den Empfangs-Optokoppler empfangene digitale Signal abhängig von der sich am Knotenpunkt (P) ergebenden Spannung erkennen können.

Die Erfindung zielt nunmehr daraufhin ab, dass anstelle von zwei Pins an der intelligenten Schaltung - ASIC oder Microcontroller - nur noch ein Pin für eine bidirektionale Daten-Kommunikation mittels zwei Optokopplers notwendig ist.

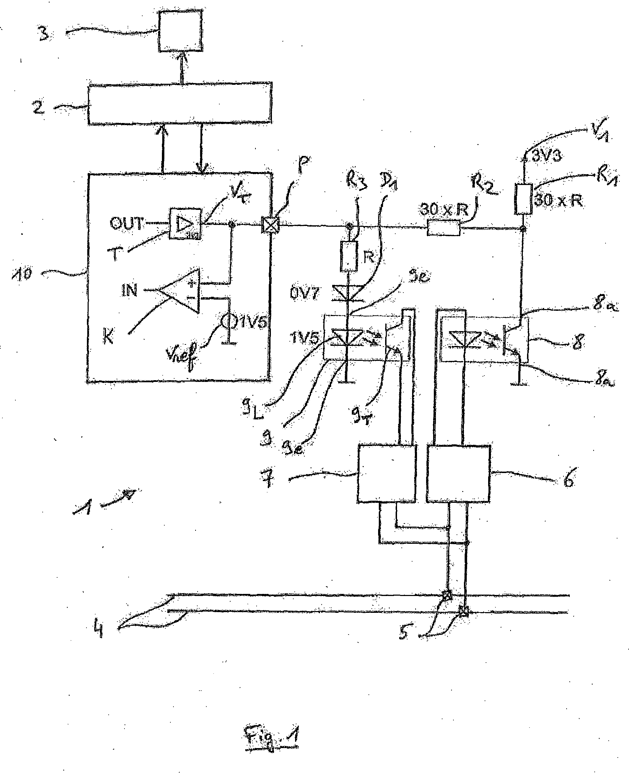

Bevorzugte Ausführungsbeispiele der Erfindung werden nachfolgend unter Bezugnahme auf die beiliegenden Zeichnungen näher erläutert. Es zeigt Fig. 1 eine schematische Darstellung einer spannungsfesten / Schnittstellenschaltung gemäß einem Ausführungsbeispiel der vorliegenden Erfindung;
Fig. 1 zeigt eine bidirektionale Schnittstelle 1 nach der vorliegenden Erfindung. Diese Schnittstelle 1 dient zum bidirektionalen Datenaustausch eines Betriebsgeräts 2 für ein bzw. mindestens ein Leuchtmittel 3 mit bspw. einer entfernten Zentrale oder einem weiteren Betriebsgerät (nicht gezeigt) über einen Bus 4. In der Schnittstelle 1 ist eine Steuerschaltung bzw. Steuer- und Auswerteschaltung 10 vorgesehen, die die Schnittstelle 1 mit dem Betriebsgerät 2 verbindet und insbesondere eine bidirektionale Kommunikation zwischen Bus 4 und Betriebsgerät 2 ermöglicht. Das Betriebsgerät 2 kann insbesondere ein elektronisches Vorschaltgerät für Leuchtmittel sein. Das Leuchtmittel 3 kann sein bspw. ein LED- oder OLED (organische Leuchtdiode)-Leuchtmittel oder auch eine Halogenlampe oder Gasentladungslampe. Das Betriebsgerät 2 kann auch allgemein für die Hausgerätetechnik zur Steuerung weiterer elektrischer Geräte dienen.

Die Schnittstelle 1 weist Anschlussklemmen 5 für den Bus 4 auf. An den Anschlussklemmen 5 sind der Eingang eines Empfangskanals bzw. Empfangszweigs 6 und der Ausgang eines Sendekanals bzw. Sendezweigs 7 zusammengeführt. Die Schnittstelle 1 ist in der Lage, über den Empfangskanal 6 Daten vom Bus zu empfangen und über den Sendekanal 7 Daten auf den Bus zu senden. Über den Empfangskanal 6, der auch als Vorwärtskanal bezeichnet wird, empfängt die Schnittstelle 1 bzw. das Betriebsgerät 2 Daten vom Bus 4. Der Sendekanal 7 ist der Rückkanal, also der Kanal über den die Schnittstelle 1 bzw. das Betriebsgerät 2 Daten auf den Bus 4 sendet.

Die empfangenen Daten können insbesondere Steuerbefehle für den Betrieb des Leuchtmittels 3 sein. Die gesendeten Daten können bspw. Informationen über den Zustand des Leuchtmittels 3 oder des Betriebsgeräts 2 betreffen. Die ausgetauschten Daten entsprechen vorzugsweise dem DALI (Digital Addressable Lighting Interface) Standard, einem Protokoll zur Steuerung von lichttechnischen Betriebsgeräten. Alternativ können die Daten gemäß dem DSI (Digital Signal Interface) Protokoll zur Steuerung von Betriebsgeräten. Vorzugsweise sind die Daten auf dem Bus 4 in digitaler Form.

Handelt es sich bspw. bei dem Bus 4 um einen DALI-Bus, wie es im Bereich der Beleuchtungstechnik eingesetzt wird, so kann ein erster Signalpegel einem physikalischen Niedrigpegel mit einem Spannungsbereich von -4,5 V bis +4,5 V entsprechen, wohingegen ein zweiter Signalpegel einem Hochpegel mit einem Spannungsbereich von +9,5 V bis + 22,5 Volt, also z. B. 16 V, oder von -9,5 V und -22,5V zugeordnet sein kann. Grundsätzlich funktioniert bei einem DALI-Bussystem die Datenübertragung so, dass im Falle eines Sendens eines Bits die Spannung auf dem Bus 4 auf Null Volt bzw. zumindest näherungsweise auf Null Volt gezogen wird, während im Ruhezustand, also falls kein Bit gesendet wird, eine Busspannung im Spannungsintervall von 9,5 bis 22,5 V, also z. B. 16 V bzw. zwischen -9,5 V und - 22,5 V, anliegt. In einem DALI-Bussystem werden also Daten durch einen Niedrigpegel übertragen. Alternativ oder zusätzlich dazu können auch Daten durch einen Hochpegel übertragen werden, wie es bspw. beim DSI Protokoll der Fall ist.

An den Ausgang des Empfangskanals 6 schließt sich ein zur Potentialtrennung dienender Optokoppler oder Empfangs-Optokoppler 8 an. Ein weiterer Optokoppler oder Sende-Optokoppler 9 ist am Eingang des Sendekanals 7 angeschlossen. Alternativ sind der Empfangs-Optokoppler 8 und der Sende-Optokoppler 9 direkt am Bus 4 angeschlossen.

Der Empfangs-Optokoppler 8 und der Sende-Optokoppler 9 sind dazu ausgebildet, einen bidirektionalen Datenaustausch zwischen der Steuerschaltung 10 und dem Bussystem und somit zwischen dem Betriebsgerät 2 und dem Bussystem zu ermöglichen. Beispielsweise kann also der Empfangs-Optokoppler 8 ausgebildet sein, um Informationen wie Steuerbefehle, die an dem Bus 4 anliegen, an die Steuerschaltung 10 und weiter an das Betriebsgerät 2 zu senden. Andererseits kann das Betriebsgerät 2 seinerseits Daten wie bspw. Zustandsinformationen an die Steuerschaltung 10 ausgeben, die diese Daten über den Sende-Optokoppler 9 dem Sehdekanal 7 zuführt und schließlich an das Bussystem überträgt. Die Steuerschaltung 10 kann z.B. analoge, vom Betriebsgerät 2 empfangene Daten in digitale Signale wie bspw. DALI- oder DSI-Signale umwandeln und dem Sendekanal 7 zuführen.

Die Steuerschaltung 10 ist vorzugsweise als integrierte Schaltung ausgestaltet, vorzugsweise in Form eines Mikrocontrollers, einer anwendungsspezifischen integrierten Schaltung (ASIC) oder eines digitalen Signalprozessors.

Erfindungsgemäß weist die Steuerschaltung einen einzigen Pin P oder Anschluss für eine bidirektionale Daten-Kommunikation über den Empfangs-Optokoppler 8 und den Sende-Optokoppler 9. Der Empfangs-Optokoppler 8 und der Sende-Optokoppler 9 sind nur über den Pin P mit der Steuerschaltung 10 verbunden. An der Steuerschaltung 10 sind somit keine zwei separaten Anschlüsse für diese Daten-Kommunikation notwendig.

Der Ausgang 8a des Empfangs-Optokopplers 8, d.h. der bspw. als Transistor ausgestaltete ausgangsseitige optische Empfänger des Empfangs-Optokopplers 8, ist in Serie mit einem ersten Widerstand R1 verbunden. Der Ausgang 8a des Empfangs-Optokopplers 8 ist mit Masse verbunden. Am ersten Widerstand R1 liegt eine Spannung V1 an.

Zwischen dem Pin P der Steuerschaltung 10 und dem Verbindungspunkt zwischen dem Empfangs-Optokopplers 8 und dem ersten Widerstand R1 ist ein zweiter Widerstand R2 geschaltet.

Am Pin P ist auch eine Serienschaltung aus einem dritten Widerstand R3, einer Diode D1 und dem Eingang 9e des Sende-Optokopplers 9, d.h. dem eingangsseitigen optischen Sender des Sende-Optokopplers 9, geschaltet. Der dritte Widerstand R3 ist insbesondere am Pin P angeschlossen. Die Kathode des optischen Senders des Sende-Optokopplers 9, bspw. in Form einer Leuchtdiode 9L, ist mit Masse verbunden. Ihre Anode ist an der Kathode der optionalen Diode D1 angeschlossen.

Die Steuerschaltung weist intern einen Treiber T und einen Komparator K auf. Der Komparator K vergleicht die Spannung am Pin P mit einer Referenzspannung Vref. Der Pin P ist am positiven, nicht-invertierenden Eingang des Komparators K angeschlossen. Die Referenzspannung Vref liegt am negativen, invertierenden Eingang des Komparators K an. Das Ausgangssignal des Komparators K wird mit IN bezeichnet. Der Ausgang des Treibers T ist am Pin P angeschlossen, wobei das Eingangssignal des Treibers T mit OUT bezeichnet wird. Abhängig von diesem Signal OUT kann am Ausgang des Treibers T eine Treiberspannung VT vorhanden sein. Ist bspw. das Signal OUT ein logisches Hoch-Signal, 'High', so wird der Treiber T am Pin P die positive Treiberspannung VT anliegen. Ist dagegen das Signal OUT ein logisches Tief-Signal 'Low', so wird der Treiber T keine Spannung VT anliegen.

Gemäß einem Ausführungsbeispiel der Erfindung können die verschiedenen Bauteile folgende Werte aufweisen:
R1=30.R, wobei R ein Widerstandswert ist,
R2=30.R,
R3=R,
V1=3,3 Volt,
Vref=1,5 Volt, und
VT=3,3 Volt.

Die Diode D1 und die Leuchtdiode 9L des Sende-Optokopplers 9 können jeweils folgende Flussspannungen aufweisen:
VD1=0,7 Volt, und
V9L=1,5 Volt.

Die Diode D1 ist dabei nur ein optionales Bauteil.

Der Treiber T und der Komparator K sind vorzugsweise interne Bauteile der Steuer- und Auswerteschaltung 10. Vorzugsweise wird auch die Referenzspannung Vref von internen Bauteilen der Steuer- und Auswerteschaltung 10 bereitgestellt. Die Komponenten der Schnittstelle 1, die nicht interne Bauteile der Steuer- und Auswerteschaltung 10 sind, sind vorzugsweise auf einer Leiterplatte angebracht.

Nachfolgend wird die Funktionsweise der erfindungsgemäßen Schnittstelle erläutert.

Im Ruhezustand des DALI-Busses 4 ist, wie oben beschrieben, der Bus-Pegel hoch. Somit wird der Empfangs-Optokoppler 8 durchschalten, so dass insbesondere der zweite Widerstand R2 auf Masse gezogen wird. Am Pin P liegt somit das Massepotential an, wodurch sich auch das Massepotential am nicht invertierten Eingang des Komparators K anliegt. Der negative weist indessen eine positive Spannung Vref auf, so dass an dem Ausgang IN des Komparators sich ein logisches Tief-Signal, Low' ergibt. Somit spiegelt das logische Tief-Signal, Low' am Ausgang IN wieder, dass sich der Bus 4 im Ruhezustand befindet bzw. dass der Bus-Pegel hoch ist.

In der vorliegenden Ausführungsform werden die logischen Verhältnisse anhand des DALI-Busses erläutert, bei dem also im Ruhezustand der Buspegel hoch ist. Bei anderen Protokollen, insbesondere DSI ist der Ruhezustand durch einen Buspegel Null gekennzeichnet, so dass sich dann die invertierten Verhältnisse ergeben.

Nachfolgend wird der Empfangsbetrieb aus Sicht der Schnittstelle bzw. des Betriebsgeräts erläutert.

Wenn der Bus bspw. in Form eines DALI-Busses sendet, erfolgt eine negative Flanke, d.h. das Bus-Potential sinkt von einem Hochpegel auf einen Niedrigpegel ab. Nach dieser negativen Flanke ist der Empfangs-Optokoppler 8 wegen dem Niedrigpegel nicht mehr durchgeschaltet, so dass das Massepotential auch nicht mehr am Pin P anliegt.

Die Wiederstands-Beschaltung ist nunmehr so ausgewählt, dass ausgehend von der Spannungsversorgung V1 die nunmehr am Pin P anliegende Spannung zwar einen Sendebetrieb der Leuchtdiode 9L ergibt, die Sendeleistung aber zu gering ist um den Transistor 9T des Sende-Optokopplers 9 durchzuschalten.

Gleichzeitig legt nunmehr am Pin P und somit am nicht invertierten Eingang des Komparators ein Signal von bspw. 2,2 Volt an, was an dem Ausgang IN das Hoch-Signal, High' ergibt, was somit die negative Flanke im Beispiel des DALI-Busses wiederspiegelt.

Diese Spannung am Pin P von bspw. 2,2 Volt ergibt sich aus der Flussspannung VD1=0,7 Volt der Diode D1 und der Flussspannung V9L=1,5 Volt der Leuchtdiode 9L. Falls gemäß einem weiteren Ausführungsbeispiel die Diode D1 nicht vorgesehen sein sollte, so würde sich am Pin P und somit am nicht invertierenden Eingang des Komparators K eine entsprechende niedrigere Spannung von bspw. 1,5 Volt ergeben. Um auch in diesem Ausführungsbeispiel am Ausgang IN das Hoch-Signal , High' zu erhalten, müsste die Referenzspannung Vref unterhalb von 1,5 Volt reduziert werden.

Nachfolgend wird der Sendebetrieb aus Sicht der Schnittstelle bzw. des Betriebsgeräts erläutert.

Als internes Bauteil in der Steuerschaltung 10 ist der Treiber für bspw. 3,3 Volt vorgesehen. Wenn dieser Treiber an dem Pin P und somit an dem dritten Widerstand R3 3,3 Volt anliegt, wird der sich durch die Leuchtdiode 9L ergebende Strom ausreichend hoch sein, um den Sende-Optokoppler 9 bzw. dessen Transistor 9T durchzuschalten.

In der Schnittstelle 1 liegt also eine derartige Asymmetrie vor, dass die 3,3 Volt von der Spannungsversorgung V1 mittels des Widerstandsnetzwerkes bestehend aus dem ersten und dem dritten Widerstand derart heruntergeteilt werden, dass der Transistor 9T des Sende-Optokopplers 9 nicht durchschaltet, während hingegen die 3,3 Volt von dem internen Treiber T des ASICs 10 ohne eine derartige Herunterskalierung an den Sende-Optokoppler angelegt werden und somit zu einem Durchschalten des sendeseitigen Optokopplers 9 führen.

Es ist festzuhalten, dass erfindungsgemäß einerseits vom Bus her und andererseits von einem internen Treiber des ASIC jeweils eine Spannung dem Sende-Optokoppler 9 zugeführt werden, wobei indessen diese Spannungen mit einem asymmetrischen Widerstandsnetzwerk zugeführt werden.

Intern ist im ASIC sichergestellt, dass der Sendebetrieb über den Treiber T nur aktiv ist, wenn gerade keine Auswertung an dem empfangsseitigen Komparator mit dem Ausgang IN vorliegt.

Das genannte Teilerverhältnis der asymmetrischen Widerstandsbeschaltung liegt in einem Faktor von wenigstens 10, bevorzugt noch höher.

### Bezugszeichen:

- 1: Schnittstelle
- 2: Betriebsgerät
- 3: Leuchtmittel
- 4: Bus
- 5: Anschlussklemmen
- 6: Empfangskanal
- 7: Sendekanal
- 8: Empfangs-Optokoppler
- 8a: Ausgang des Empfangs-Optokopplers
- 9: Sende-Optokoppler
- 9e: Eingang des Sende-Optokopplers
- 9L: Leuchtdiode des Sende-Optokopplers
- 9T: Transistor 9T des Sende-Optokopplers
- 10: Steuerschaltung oder Steuer- und Auswerteschaltung

## Patentansprüche

1. Schnittstellenschaltung (1) für ein Betriebsgerät (2) der Hausgerätetechnik, aufweisend einen Sende-Optokoppler (9) und einen Empfangs-Optokoppler (8) zur bidirektionalen Kommunikation mit einem Bus (4) über den Sende-Optokoppler (9) und den Empfangs-Optokoppler (8),
wobei die Schnittstellenschaltung (1) derart ausgebildet ist, dass an einem Knotenpunkt (P) der Zustand des Empfangs-Optokopplers (8) detektierbar ist, so dass ein Signal vom Bus (4) empfangen werden kann, wobei eine Treiberspannung (VT) den Sende-Optokoppler (9) durchschaltet und der Sende-Optokoppler somit ein Signal auf den Bus (4) sendet,
**dadurch gekennzeichnet, dass**
die Schnittstellenschaltung (1) weiterhin derart ausgebildet ist, dass derselbe Knotenpunkt (P) der Schnittstellenschaltung (1) mit der Treiberspannung (VT) am Ausgang eines Treibers (T) der Schnittstellenschaltung (1) beaufschlagbar ist.

2. Schnittstellenschaltung nach Anspruch 1,
wobei der Knotenpunkt (P) ein Anschluss einer Steuer- und Auswerteschaltung (10) ist.

3. Schnittstellenschaltung nach einem der vorigen Ansprüche,
wobei die Steuer- und Auswerteschaltung (10) Mittel aufweist, z.B. einen Komparator (K), zum Vergleichen der Spannung am Knotenpunkt (P) mit einer Referenzspannung (Vref),
wobei abhängig von diesem Vergleich auf ein Niedrigpegel- oder Hochpegel-Signal auf dem Bus (4) geschlossen wird.

4. Schnittstellenschaltung nach Anspruch 3,
wobei, wenn die Spannung am Knotenpunkt (P) größer als die Referenzspannung (Vref) ist, auf ein Niedrigpegel-Signal auf dem Bus (4) geschlossen wird, und
wenn die Spannung am Knotenpunkt (P) kleiner als die Referenzspannung (Vref) ist, auf ein Hochpegel-Signal auf dem Bus (4) geschlossen wird

5. Schnittstellenschaltung nach Anspruch 3 oder 4,
wobei der Bus (4) als DALI-Bus ausgestaltet ist und ein detektiertes Hochpegel-Signal auf dem Bus (4) als Ruhezustand des Busses'(4) interpretiert wird.

6. Schnittstellenschaltung nach einem der vorigen Ansprüche,
wobei die Steuer- und Auswerteschaltung (10) als integrierte Schaltung ausgestaltet ist, vorzugsweise in Form eines Mikrocontrollers, einer anwendungsspezifischen integrierten Schaltung (ASIC) oder eines digitalen Signalprozessors.

7. Schnittstellenschaltung nach einem der vorigen Ansprüche,
aufweisend:
- einen am Knotenpunkt (P) angeschlossenen ersten Strompfad aufweisend eine niederohmige Schaltung (R3) und den Sende-Optokoppler (9),
- einen am Knotenpunkt (P) angeschlossenen, mit einer Versorgungsspannung (V1) versorgten, hochohmigen zweiten Strompfad, der mit einem Empfangs-Optokoppler (8) verbunden ist.

8. Schnittstellenschaltung nach Anspruch 7,
wobei der Empfangs-Optokoppler (8) derart mit dem hochohmigen zweiten Strompfad verbunden ist, dass ein Durchschalten des Empfangs-Optokopplers (8) am Knotenpunkt (P) ein Niedrigpotential verursacht.

9. Schnittstellenschaltung nach Anspruch 7 oder 8,
wobei der Empfangs-Optokoppler (8) derart mit dem hochohmigen zweiten Strompfad verbunden ist, dass ein Nicht-Durchschalten des Empfangs-Optokopplers (8) am Knotenpunkt (P) ein Hochpotential verursacht.

10. Schnittstellenschaltung nach Anspruch 9,
wobei der Empfangs-Optokoppler (8) derart mit dem hochohmigen zweiten Strompfad verbunden ist, dass ein Nicht-Durchschalten des Empfangs-Optokopplers (8) ein Nicht-Durchschalten des Sende-Optokopplers (9) verursacht.

11. Schnittstellenschaltung nach einem der vorigen Ansprüche,
wobei dem Sende-Optokoppler (9) einerseits die Treiberspannung (VT) und andererseits eine mit dem Empfangs-Optokoppler (8) gekoppelte Versorgungsspannung (V1) zuführbar sind.

12. Schnittstellenschaltung nach Anspruch 11,
aufweisend ein asymmetrisches Widerstandsnetzwerk derart, dass beim Zuführen der Treiberspannung (VT) der Sende-Optokoppler (9) durchschaltet und beim Zuführen der Versorgungsspannung (V1) der Sende-Optokoppler (9) nicht durchschaltet.

13. Schnittstellenschaltung nach einem der vorigen Ansprüche,
wobei, bei Nichtbeaufschlagung des Knotenpunkts (P) mit der Treiberspannung (VT), der Sende-Optokoppler (9) nicht durchschaltet und die Steuer- und Auswerteschaltung (10) das über den Empfangs-Optokoppler (8) empfangene digitale Signal abhängig von der sich am Knotenpunkt (P) ergebenden Spannung erkennen kann.

14. Betriebsgerät für Leuchtmittel aufweisend eine Schnittstellenschaltung (1) nach einem der vorigen Ansprüche.

## Claims

1. An interface circuit (1) for an operating device (2) of household appliance technology, having a transmitting optical coupler (9) and a receiving optical coupler (8) for bidirectional communication with a bus (4) via the transmitting optical coupler (9) and the receiving optical coupler (8),
wherein the interface circuit (1) is designed in such a manner that at a nodal point (P) the state of the receiving optical coupler (8) can be detected, so that a signal can be received from the bus (4),
wherein a driving voltage (VT) switches through the transmitting optical coupler (9) and the transmitting optical coupler thus transmits a signal to the bus (4),
**characterized in that**
the interface circuit (1) is furthermore designed in such a manner that the same nodal point (P) of the interface circuit (1) can be subjected to the driving voltage (VT) at the outlet of the driver (T) of the interface circuit (1).

2. An interface circuit according to Claim 1,
wherein the nodal point (P) is a connection of a control and evaluation circuit (10).

3. An interface circuit according to any one of the preceding claims,
wherein the control and evaluation circuit (10) has means, for example, a comparator (K), for comparing the voltage at the nodal point (P) with a reference voltage (Vref), wherein depending on this comparison a low-level or high-level signal to the bus (4) is deduced.

4. An interface circuit according to Claim 3,
wherein, if the voltage at the nodal point (P) is greater than the reference voltage (Vref) a low level signal to the bus (4) is deduced, and
if the voltage at the nodal point (P) is smaller than the reference voltage (Vref), a high level signal to the bus (4) is deduced.

5. An interface circuit according to Claim 3 or 4,
wherein the bus (4) is designed as a DALI bus and a detected high-level signal to the bus (4) is interpreted as an idle state of the bus (4).

6. An interface circuit according to any one of the preceding claims,
wherein the control and evaluation circuit (10) is designed as an integrated circuit, preferably in the form of a microcontroller, an application-specific integrated circuit (ASIC) or a digital signal processor.

7. An interface circuit according to any one of the preceding claims,
having:
- a first current path connected to a nodal point (P) having a low-impedance circuit (R3) and a transmitting optical coupler (9),
- a high-impedance second current path connected to the nodal point (P), supplied with a supply voltage (V1), which current path is connected with a receiving optical coupler (8).

8. An interface circuit according to Claim 7,
wherein the receiving optical coupler (8) is connected with the high-impedance second current path in such a manner that a switching through of the receiving optical coupler (8) at the nodal point (P) causes a low potential.

9. An interface circuit according to Claim 7 or 8,
wherein the receiving optical coupler (8) is connected with the high-impedance second current path in such a manner that a non-switching through of the receiving optical coupler (8) at the nodal point (P) causes a high potential.

10. An interface circuit according to claim 9,
wherein the receiving optical coupler (8) is connected with the high-impedance second current path in such a manner that a non-switching through of the receiving optical coupler (8) causes a non-switching through of the transmitting optical coupler (9).

11. An interface circuit according to any one of the preceding claims,
wherein the transmitting optical coupler (9), on the one hand, can be supplied with the driving voltage (VT) and, on the other hand, with a supply voltage (V1) coupled with the receiving optical coupler (8).

12. An interface circuit according to Claim 11,
having an asymmetrical resistance network such that when the driving voltage (VT) is supplied the transmitting optical coupler (9) switches through and when the supply voltage (V1) is supplied the transmitting optical coupler (9) does not switch through.

13. An interface circuit according to any one of the preceding claims,
wherein when the nodal point (P) is not subjected to the driving voltage (VT), the transmitting optical coupler (8) does not switch through and the control and evaluation circuit (10) can detect the digital signal received via the receiving optical coupler (8) depending on the voltage arising at the nodal point (P).

14. An operating device for lamps having an interface circuit (1) according to any one of the preceding claims.

## Revendications

1. Circuit d'interface (1) pour un appareil de commande (2) d'électroménager, comprenant un optocoupleur émetteur (9) et un optocoupleur récepteur (8) pour la communication bidirectionnelle avec un bus (4) par l'intermédiaire de l'optocoupleur émetteur (9) et de l'optocoupleur récepteur (8),
le circuit d'interface (1) étant conçu de façon à ce que, au niveau d'un point nodal (P), l'état de l'optocoupleur récepteur (8) puisse être détecté de façon à ce qu'un signal puisse être reçu par le bus (4),
une tension de pilotage (VT) commutant l'optocoupleur émetteur (9) et l'optocoupleur émetteur envoyant ainsi un signal sur le bus (4),
**caractérisé en ce que**
le circuit d'interface (1) est en outre conçu de façon à ce que le même point nodal (P) du circuit d'interface (1) peut être alimenté avec une tension de pilotage (VT) à la sortie d'un pilote (T) du circuit d'interface (1).

2. Circuit d'interface selon la revendication 1,
le point nodal (P) étant une borne d'un circuit de commande et d'analyse (10).

3. Circuit d'interface selon l'une des revendications précédentes,
le circuit de commande et d'analyse (10) comprenant des moyens, par exemple un comparateur (K), pour la comparaison de la tension au niveau du point nodal (P) avec une tension de référence (Vref),
moyennant quoi, en fonction de cette comparaison, un signal de bas niveau ou de haut niveau étant déduit sur le bus (4).

4. Circuit d'interface selon la revendication 3,
moyennant quoi, lorsque la tension au point nodal (P) est supérieure à la tension de référence (Vref), il est déduit un signal de bas niveau sur le bus (4) et
lorsque la tension au point nodal (P) est inférieure à la tension de référence (Vref), il est déduit un signal de bas niveau sur le bus (4).

5. Circuit d'interface selon la revendication 3 ou 4,
moyennant quoi le bus (4) est conçu comme un bus DALI et un signal de haut niveau détecté sur le bus (4) est interprété comme un état de repos du bus (4).

6. Circuit d'interface selon l'une des revendications précédentes,
le circuit de commande et d'analyse (10) étant conçu comme un circuit intégré, de préférence sous la forme d'un microcontrôleur, d'un circuit intégré spécifique à l'application (ASIC) ou d'un processeur de signal numérique.

7. Circuit d'interface selon l'une des revendications précédentes,
comprenant :
- un premier trajet de courant branché au point nodal (P), comprenant un circuit à faible valeur ohmique (R3) et l'optocoupleur émetteur (9),
- un deuxième trajet de courant à forte valeur ohmique, branché au point nodal (P) et alimenté avec une tension d'alimentation (V1), qui est relié avec un optocoupleur récepteur (8).

8. Circuit d'interface selon la revendication 7,
l'optocoupleur récepteur (8) étant relié avec le deuxième trajet de courant à forte valeur ohmique de façon à ce qu'une commutation de l'optocoupleur récepteur (8) au niveau du point nodal (P) produit un potentiel faible.

9. Circuit d'interface selon la revendication 7 ou 8,
l'optocoupleur récepteur (8) étant relié avec le deuxième trajet de courant à forte valeur ohmique de façon à ce qu'une non-commutation de l'optocoupleur récepteur (8) au niveau du point nodal (P) produit un potentiel élevé.

10. Circuit d'interface selon la revendication 9,
l'optocoupleur récepteur (8) étant relié avec le deuxième trajet de courant à forte valeur ohmique de façon à ce qu'une non-commutation de l'optocoupleur récepteur (8) provoque une non-commutation de l'optocoupleur émetteur (9).

11. Circuit d'interface selon l'une des revendications précédentes,
la tension de pilotage (VT) d'une part et une tension d'alimentation (V1) couplée avec l'optocoupleur récepteur (8) d'autre part étant appliquées à l'optocoupleur émetteur (9).

12. Circuit d'interface selon la revendication 11,
comprenant un réseau de résistance asymétrique de façon à ce que, lors de l'application de la tension de pilotage (VT), l'optocoupleur émetteur (9) commute et, lors de l'application de la tension d'alimentation (V1), l'optocoupleur émetteur (9) ne commute pas.

13. Circuit d'interface selon l'une des revendications précédentes,
moyennant quoi, dans le cas d'une non-application de la tension de pilotage (VT) au point nodal (P), l'optocoupleur émetteur (9) ne commute pas et le circuit de commande et d'analyse (10) peut détecter le signal numérique reçu par l'intermédiaire de l'optocoupleur récepteur (8) en fonction de la tension qui en résulte au niveau du point nodal (P).

14. Appareil de commande pour moyens d'éclairage, comprenant un circuit d'interface (1) selon l'une des revendications précédentes.
